# EUROPEAN PATENT APPLICATION

(11) **EP 4 571 329 A1**
(43) Date of publication of application: **18.06.2025**
(21) Application number: 23216624.9
(22) Date of filing: 14.12.2023
(51) Int. Cl.: G01R 31/00, B60L 3/00, G01R 31/28

(54) **FAULT DETECTOR AND METHOD FOR DETECTING FAULTS IN COMPONENTS IN A VEHICLE**

(71) Applicant: VOLVO TRUCK CORPORATION, 405 08 Göteborg (SE)
(72) Inventor: LAM, Henrik, 603 55 Norrköping (SE); LARSSON, Michael, 439 92 Onsala (SE)
(74) Representative: Valea AB

(57) **Abstract**

The present disclosure relates to a method performed by a fault detector (301) for detecting faults in components (105) in a vehicle (100). The fault detector (301) is connected in parallel to at least one component (105) of at least two serially connected components (202). The at least two serially connected components (105) are divided into at least two sections (303) each comprising at least one component (105). The method comprises:
- obtaining (501) a first voltage level at an input point into each section (303);
- obtaining (502) a second voltage level at an output point from each section (303);
- comparing (503) the first voltage level with the second voltage level for each section and such that the voltage level over each section (303) is determined; and
- determining (504) whether or not there is an indication of a fault in each section (303).

## Description

### TECHNICAL FIELD

The disclosure relates generally to a fault detector, a method performed by a fault detector, a fault detection system and a vehicle. In particular aspects, the disclosure relates to detecting faults in components in a vehicle. The disclosure can be applied to heavy-duty vehicles, such as trucks, buses, marine vessels and construction equipment, among other vehicle types. Although the disclosure may be described with respect to a particular vehicle, the disclosure is not restricted to any particular vehicle.

### BACKGROUND

In a vehicle, faults may occur that cause hazardous voltages. Hazardous voltages are unwanted and should be detected such that the hazardous voltages and/or their cause can be removed or at least mitigated. A vehicle typically comprises a fault detection system for detecting such faults. A Hazardous Voltage Interlock Loop (HVIL) is used in fault detection systems. A HVIL is a part of the Traction Voltage Monitoring Unit (TVMU) in a vehicle and is used for detecting a hazard voltage. A hazardous voltage may be caused by a fault in a component of the vehicle. A hazardous voltage may be a voltage higher than 60 VDC or 30 VAC. HVIL may sometimes be an abbreviation for High Voltage Interlock Loop, which may be the same as Hazardous Voltage Interlock Loop. The HVIL may be described as being arranged to ensure that all high voltage and current sources of a system are shut off in the event of an intrusion or a failure.

Current fault detection systems are not sufficiently reliable system. For example, all signals below 10 milliseconds will also be filtered out, and this contributes to that cable faults and loose contacts faults often go undetected.

In view of the above, there is a strive to develop further improved technology relating to fault detection in vehicles.

### SUMMARY

According to a first aspect of the disclosure, a method performed by a fault detector for detecting faults in components in a vehicle is provided. The fault detector is connected in parallel to at least one component of at least two serially connected components. The HVIL is connected to a first component amongst the at least two serially connected components. The at least two serially connected components are divided into at least two sections. Each section comprises at least one component. The method comprising:
- obtaining a first voltage level at an input point into each section;
- obtaining a second voltage level at an output point from each section;
- comparing the first voltage level with the second voltage level for each section and such that the voltage level over each section is determined; and
- based on a result of the comparison, determining whether or not there is an indication of a fault in each section.

The first aspect of the disclosure may seek to improve fault detection in components in a vehicle. A technical benefit may include that fault detection in components in a vehicle is improved. Another technical benefit may include increased electrical safety in the vehicle.

Optionally in some examples, including in at least one preferred example, the method may comprise:
- determining that there is an indication of a fault in the section when the result of the comparing indicates a difference between the first voltage level and the second voltage level and/or indicates that the difference has reached or exceeded a voltage threshold.

A technical benefit may include that an indication of the fault may easily be determined, and also with high accuracy.

Optionally in some examples, including in at least one preferred example, the method may comprise:
- determining that there is no indication of fault in the section when the result of the comparing does not indicate a difference between the first voltage level and the second voltage level and/or that the difference has not reached or exceeded a voltage threshold.

A technical benefit may include that it may easily and accurately be determined that there is no fault present in the section.

Optionally in some examples, including in at least one preferred example, the method may comprise:
- when there is an indication of the fault, analyzing the first voltage level and the second voltage level to determine a type and/or a root of the fault.

A technical benefit may include that, when the type and/or root of the fault is determined it may be possible to take the necessary action in order to remove the fault or at least mitigate the fault.

Optionally in some examples, including in at least one preferred example, the first voltage level and the second voltage level may be obtained continuously.

A technical benefit may include that an indication of a fault may be determined directly when it occurs. There may be no or limited delay from obtaining the voltage level to determining the indication of the fault. Thus, the harm that the fault may have caused may be mitigated early and with a minimum damage to the component.

Optionally in some examples, including in at least one preferred example, the method may comprise:
- storing information indicating the first voltage level and/or the second voltage level and/or information indicating the result of the comparison.

A technical benefit may include that the first voltage level and/or the second voltage level may be used for further examination. This may be advantageous for example in designing future components where faults that have previously occurred should not occur again.

Optionally in some examples, including in at least one preferred example, the storing of the first voltage level and/or second voltage level and/or information indicating the result of the comparison may be triggered by that the difference between the first voltage level and the second voltage level has reached or exceeded the voltage threshold.

A technical benefit may include that the voltage threshold may be set to best suit the component, the configuration of the vehicle etc. In other words, the voltage threshold may be tailormade to the specific application. When an indication of the fault is determined, it may be a relevant indication for the specific application. An indication of a fault that is not relevant for the application may not necessarily be determined.

Optionally in some examples, including in at least one preferred example, the first voltage level and the second voltage level may be obtained at a sampling rate below 10 milliseconds.

A technical benefit may include that the fault detector may have a high enough sampling speed to be able to sample and store signals below 10 milliseconds. These signals are otherwise filtered out and may comprise useful information for the identity of the fault type.

According to a second aspect of the disclosure, a fault detector for detecting faults in components in a vehicle is provided. The fault detector is arranged to be connected in parallel to at least one component of at least two serially connected components. The HVIL is arranged to be connected to a first component amongst the at least two serially connected components. The at least two serially connected components are divided into at least two sections. Each section comprises at least one component. The fault detector is arranged to:
- obtain a first voltage level at an input point into each section;
- obtain a second voltage level at an output point from each section;
- compare the first voltage level with the second voltage level for each section and such that the voltage level over each section is determined; and to
- based on a result of the comparison, determine whether or not there is an indication of a fault in each section.

The second aspect of the disclosure may seek to improve fault detection in components in a vehicle. A technical benefit may include that fault detection in components in a vehicle is improved. Another technical benefit may include increased electrical safety in the vehicle.

Optionally in some examples, including in at least one preferred example, the fault detector may be arranged to:
- determine that there is an indication of a fault in the section when the result of the comparing indicates a difference between the first voltage level and the second voltage level and/or indicates that the difference has reached or exceeded a voltage threshold.

A technical benefit may include that an indication of the fault may easily be determined, and also with high accuracy.

Optionally in some examples, including in at least one preferred example, the fault detector may be arranged to:
- determine that there is no indication of fault in the section when the result of the comparing does not indicate a difference between the first voltage level and the second voltage level and/or that the difference has not reached or exceeded a voltage threshold.

A technical benefit may include that it may easily and accurately be determined that there is no fault present in the section.

Optionally in some examples, including in at least one preferred example, the fault detector may be arranged to:
- when there is an indication of the fault, analyze the first voltage level and the second voltage level to determine a type and/or a root of the fault.

A technical benefit may include that, when the type and/or root of the fault is determined it may be possible to take the necessary action in order to remove the fault or at least mitigate the fault.

Optionally in some examples, including in at least one preferred example, the first voltage level and the second voltage level may be obtained continuously.

A technical benefit may include that an indication of a fault may be determined directly when it occurs. There may be no or limited delay from obtaining the voltage level to determining the indication of the fault. Thus, the harm that the fault may have caused may be mitigated early and with a minimum damage to the component.

According to a third aspect of the disclosure, fault detection system for detecting faults in components in a vehicle is provided. The fault detection system comprises a fault detector according to the second aspect and at least two serially connected components.

The third aspect of the disclosure may seek to improve fault detection in components in a vehicle. A technical benefit may include that fault detection in components in a vehicle is improved. Another technical benefit may include increased electrical safety in the vehicle.

According to a fourth aspect of the disclosure a vehicle is provided. The vehicle comprises the fault detection system according to the third aspect.

The fourth aspect of the disclosure may seek to improve fault detection in components in a vehicle. A technical benefit may include that fault detection in components in a vehicle is improved. Another technical benefit may include increased electrical safety in the vehicle.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1** is an exemplary illustration of a vehicle according to an example.
**FIG. 2** is an exemplary block diagram illustrating a HVIL system according to an example.
**FIG. 3** is an exemplary block diagram illustrating a HVIL system according to an example.
**FIG. 4** is an exemplary block diagram illustrating a HVIL system according to an example.
**FIG. 5** is an exemplary flow chart illustrating a method according to an example.
**FIG. 6** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

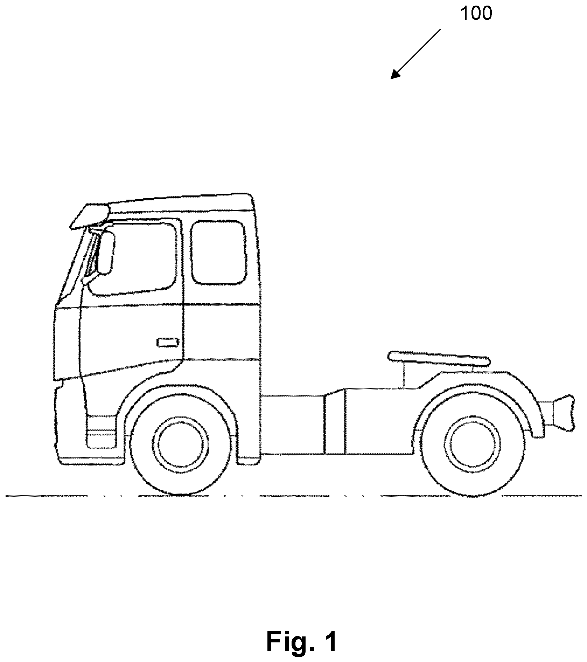

**FIG. 1** is an exemplary block diagram illustrating a vehicle **100** according to an example. The disclosure can be applied to heavy-duty vehicles, such as trucks, buses and construction equipment, among other vehicle types. Although the disclosure may be described with respect to a particular vehicle, the disclosure is not restricted to any particular vehicle, but may also be used in other vehicles such as buses, trailers, wheel loaders, articulated haulers, excavators, backhoe loaders, passenger cars, marine vessels etc. It may also be applied in various industrial construction machines or working machines. The disclosure is applicable in fully electrically operated vehicles as well as in hybrid vehicles, comprising also a combustion engine, and in vehicles only operated by a combustion engine, i.e. not having any electrical engine. The term vehicle **100** will be used herein when referring to any of the above types of vehicles.

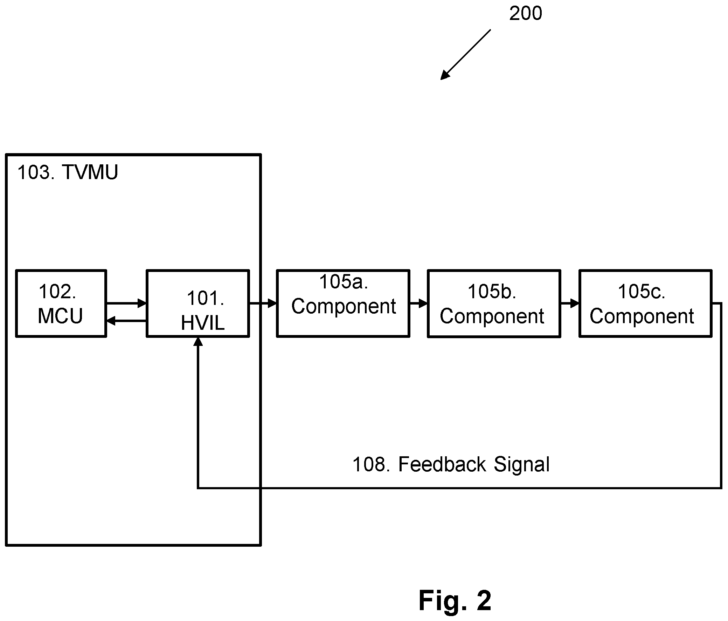

**FIG. 2** is a schematic illustration of a current HVIL system **200.** As seen in **FIG. 2**, the HVIL **101** is connected to a Micro Controller Unit (MCU) **102.** The HVIL **101** and the MCU **102** are both arranged to transmit and receive signals from each other, as indicated with the two arrows in **FIG. 2****.** The abbreviation HVIL **101** is used when referring to a HVIL circuity, a HVIL entity, a HVIL unit, a HVIL component etc. The HVIL **101** and the MCU **102** are comprised in a TVMU **103.** The TVMU **103** may comprise other entities in addition to the HVIL **101** and the MCU **102** but are not illustrated in **FIG. 2** for the sake of simplicity. The HVIL **101** is connected to one of a number of serially connected components **105.** **FIG. 2** shows an example with three components **105a**, **105b** and **105c.** The reference number **105** will be used herein when referring to any of the components. Note that the number of three components is only an example and that there may be any n number of components **105** in the HVIL system **200**, where n is a positive integer. A feedback signal **108**, also referred to as a feedback loop, goes from the output of the last component **105c** in the series to the HVIL **101.**

For fault tracing in the current HVIL system **200**, the current in the loop is measured with the help of a feedback signal **108** and whenever a faulty behaviour has been detected, the loop, i.e. the connection between the HVIL 101 and the components 105, will be disconnected. When a faulty behaviour has been detected, a diagnostic trouble code will be set. The current HVIL system **200** utilizes the Controller Area Network (CAN) communication protocol. The current HVIL system **200** can detect both open and short circuit faults with the help of upstream and/or downstream signals from the active components **105.** An active component **105** may be semiconductor components such as for example transistors, diodes etc. An active component **105** has the ability to modify an electric signal, such as amplifying, rectifying etc. However, the HVIL system **200** is not a sufficiently reliable system since the active components **105** can behave very differently when a faulty behaviour occurs. All signals below 10 milliseconds will also be filtered out, and this contributes to that cable faults and loose contacts faults often go undetected.

The present disclosure improves the fault tracing aspect of the HVIL system. A fault may be, for example, an open cable, a loose contact, a component failure etc. By adding a fault detector and voltage measurement nodes in the HVIL system, this contributes to the fact that it is possible to divide components into smaller sections and monitor each section individually. The voltage measurement node may be referred to as a voltage measurement point, and it may be an input point or an output point of a section. One of the voltage measurements will act as voltage reference. The fault detector will monitor and compare the behaviour of the voltage level, and optionally process and store the voltage values. The fault detector may have a high enough sampling speed to be able to sample and store signals below 10 milliseconds, since these signals are otherwise filtered out and contain useful information for the identity of the fault type.

By comparing the voltage values, it may be possible to narrow down the root of the faulty behaviour to a section such that it may be determined that the faulty behaviour originates from a particular section. Having the ability to be able to sample and store signals below 10 milliseconds will contribute to having the ability to determine and identify types of faults that are undetected in the current version of HVIL system. Examples of such faults may be for example, open cable faults, loose contacts faults and component failures.

The precision of the fault detector may be determined by the amount of available measurement nodes or measurement points in the HVIL system. By adding more measurement nodes or measurement points, the components may be divided into even sections having less components than the whole system. With less components within a section, the precision of the fault detection will increase as there are less components from which the fault may originate. Therefore, improving the precision of the fault detector.

Some feature of the disclosure may be summarized as follows:
- The components are divided into smaller sections and each section is monitored individually.
- The measured voltage values and/or an indication of a fault may be stored for further examination.
- Open cable, loose contact and component failure faults may be detected.
- The precision of the fault detector may rely on the amount of available measurement nodes or measurement points in the fault detection system.

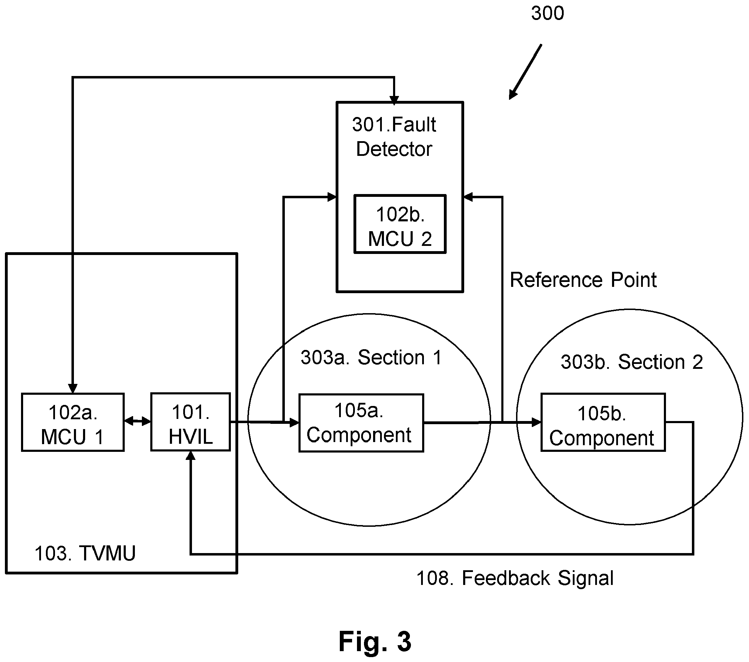

**FIG. 3** is an exemplary block diagram illustrating a fault detection system **300** according to an example. The fault detection system **300** is arranged to be comprised in the vehicle **100.** The fault detection system **300** comprises a HVIL **101.** The abbreviation HVIL **101** is used when referring to a HVIL circuity, a HVIL entity, a HVIL unit, a HVIL component etc.

The HVIL **101** is arranged to be connected to a first MCU 1 **102a**. The first MCU 1 **102a** is arranged to control the fault detection system 300. The HVIL 101 and the first MCU 1 **102a** are both arranged to transmit and receive signals from each other. The first MCU 1 **102a** is arranged to act as a controller and a power source for the HVIL 101. The power source provides an analog signal.

The HVIL **101** and the first MCU 1 **102a** are comprised in a TVMU **103.** The TVMU **103** may comprise other entities in addition to the HVIL 101 and the first MCU 1 **102a** but are not illustrated in **FIG. 3** for the sake of simplicity.

The HVIL **101** is connected to a first component **105a** of a number of serially connected components **105.** The HVIL **101** is arranged to send a signal to the first component **105a** of the serially connected components **105.** The HVIL **101** is arranged to send a signal such as a current signal of around 15 mA to supply the serially connected components **105.** A current signal of around 15 mA may be transmitted between the components **105.** **FIG. 3** shows an example with two components **105a** and **105b.** The reference number **105** will be used herein when referring to any of the components. Note that is any *n*+*1* number of components **105** in the fault detection system **300**, where n is a positive integer. In other words, the fault detection system **300** comprises at least two serially connected components **105**, and the HVIL **101** is arranged to be connected to the first component **105a** amongst the at least two serially connected components **105.** The component **105** may be for example a battery such as a traction battery, a DC/DC converter, an air compressor or any other suitable component comprised in the vehicle **100.** The serially connected components **105** may be of the same or different component type, where the type may be a traction battery, a DC/DC converter, an air compressor or any other suitable component type comprised in the vehicle **100.**

**FIG. 3** illustrates an example with one series of connected components **105**, but the vehicle **100** may comprise one, two or more series of connected components **105.** One series of connected components **105** may comprise any suitable number of components **105**, for example between 2-10 components. Only components **105** in the same series of components **105** may be divided into sections **303.**

The at least two serially connected components **105** are divided into at least two sections **303.** This may be described as the at least two serially connected components **105** are grouped into at least two sections **303.** A section may be referred to as a group, a cluster, a subpart etc. **FIG. 3** illustrates a first section 1 **303a** and a second section 2 **303b**, but this is only an example of the number of sections **303.** The at least two serially connected components **105** may be divided to any *m*+*1* number of sections, where *m* is a positive integer. The reference number **303** may be used herein when referring to any of the sections **303** in the fault detection system **300.** Each section **303** comprises at least one component **105.** The at least two sections **303** are serially connected sections **303.** Each section **303** may comprise the same number of components **105** or they may comprise a different number of components **105.** The components **105** in each section may be of the same type or of a different types.

Each section **303** comprises less components **105** compared to the total amount of serially connected components **105** in the fault detection system **300.** With less components within a section **303**, the precision of the fault detection will increase as there are less components **105** from which the fault may originate.

The feedback signal **108**, also referred to as a feedback loop, goes from the output of the last component **105b** in the at least two serially connected components **105** and back into the HVIL **101.** In the example of **FIG. 3**, the feedback signal **108** goes from the output of the second component **105b** and fed back into the HVIL **101.** The feedback signal **108** may be a current signal.

A fault detector **301** is connected via wire in parallel to at least one component **105** of the at least two serially connected components **105.** In the example illustrated in **FIG. 3** with two components **105**, the fault detector **301** is connected in parallel to the first component **105a** but this is only an example. In another example, the fault detector **301** is connected to the first component **105a**, and the second component **105b** (not exemplified in **FIG. 3**). The fault detector **301** is arranged to monitor and receive signals from one or more components **105**, from one or more sections **303**, from an input point into a section **303** and/or an output point at output from a section **303** etc. The signal may be a voltage signal or information representing the voltage at the input point and/or output point. The fault detector **301** may comprise any suitable entity arranged to monitor and obtain the voltage level.

The fault detector **301** is arranged to transmit and receive signals from a second MCU 2 **102b.** The fault detector **301** may receive a digital signal from the second MCU 2 **102b** to start sampling. The fault detector **301** may transmit analog signals, e.g. voltage levels, back to the second MCU 2 **102b.**

In the example of **FIG. 3**, the signal input from the HVIL **101** into the first section **303a** is input into the fault detector **301.** The output signal from the first section **303a** is input into the fault detector **301.** The output signal from the first section **303a** may be referred to as a reference signal or a reference point.

The fault detector **301** is arranged to be connected to the TVMU **103**, e.g. to the HVIL **101** comprised in the TVMU **103.**

The fault detector **301** comprises a second MCU 2 **102b.** The first MCU 1 **102a** and the second MCU 2 **102b** are both arranged to transmit and receive signals to and from each other, e.g. digital signals for communicating with each other and for performing operations. The second MCU 2 **102b** is arranged to act as a controller and/or data processing unit for the fault detector **301.** The second MCU 2 **102b** is arranged to control the fault detector **301** and process the data, e.g. voltage levels. The MCU 2 **102b** may be a processing circuity, or it may comprise a processing circuit.

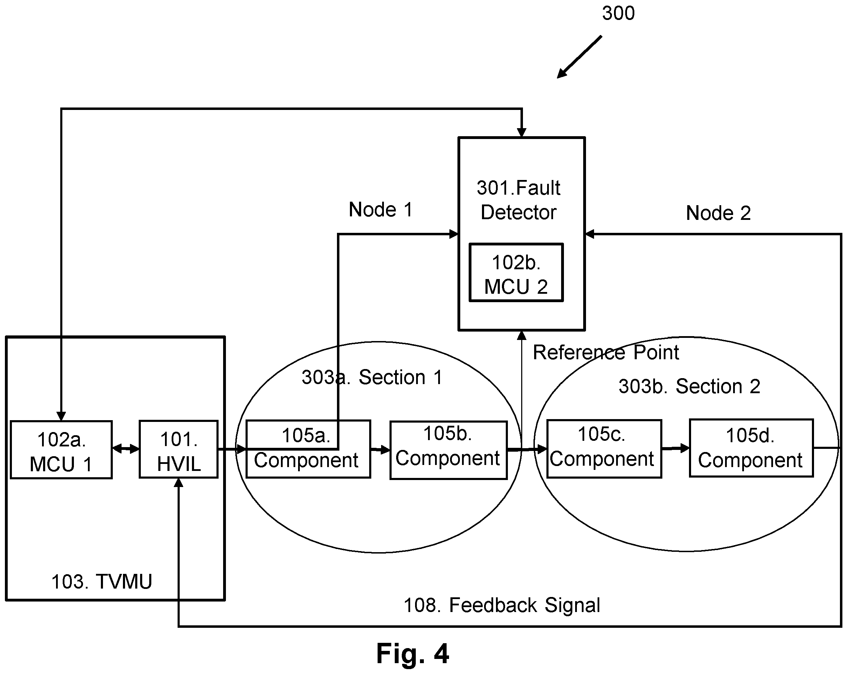

**FIG. 4** is an exemplary block diagram illustrating a fault detection system **300** according to an example. The fault detection system **300** exemplified in **FIG. 4** comprises the same entities as the system illustrated in **FIG. 3**, except for the number of components **105.** The description of the entities that are the same as in **FIG. 3** will not be repeated for the sake of simplicity.

The example illustrated in **FIG. 4** illustrates four components **105a**, **105b**, **105c** and **105d.The** components **105** may be for example a traction battery, a DC/DC converter, an air compressor or any other suitable component comprised in the vehicle **100.** The at least two serially connected components **105** are divided into at least two sections **303.** **FIG. 4** illustrates a first section 1 **303a** and a second section 2 **303b**, but this is only an example of the number of sections **303.** Each section **303** in the fault detection system **300** exemplified in **FIG.** 4 comprises two components 105. The first section 1 **303a** comprises a first component **105a** and a second component 105b. The second section 2 **303b** comprises a second component 105c and a third component **105d.**

**FIG.** 4 illustrates an example with one series of connected components 105, but the vehicle 100 may comprise one, two or more series of connected components 105. One series of connected components 105 may comprise any suitable number of components 105, for example between 2-10 components. Only components 105 in the same series of components may be divided into sections 303.

The feedback signal 108, also referred to as a feedback loop, goes from the output of the last component 105 in the at least two serially connected components 105 and back into the HVIL 101. In the example of FIG. 4, the feedback signal 108 goes from the output of the fourth component **105b** and fed back into the HVIL 101.

As mentioned above, the fault detector 301 is connected in parallel to at least one component 105 of the at least two serially connected components 105. In the example illustrated in **FIG. 4** with four components **105**, the fault detector **301** is connected in parallel all four components **105a, 105, 105c, 105d** but this is only an example.

In the example of **FIG. 4**, the signal input from the HVIL **101** into the first section **303a** is input into the fault detector **301**, the output signal from the first section **303a** is input into the fault detector **301**, and the output signal from the second section **303b** is input into the fault detector **301.** The output signal from the first section **303a** may also be the input signal into the second section **303b.**

The fault detector **301** will be connected through cable in parallel to the components **105.** While the components **105** are active, the fault detector **301** will measure the voltage of the measurement nodes, Node 1, Node 2 and Reference point. Using the example in **FIG. 4**, the node 1 may correspond to an input point in to the first section 1 **303a**, the reference point may correspond to the output point of the first section 1 **303a,** the reference point may correspond to the input point into the second section **303b** and Node 2 may correspond to the output point of the second section 2 **303b.** The fault detector **301** will compare the measured voltages, in this case, the measured voltage from Node 1 will be compared to the voltage from the Reference Point (reference voltage). If the compared voltage is not at an expected value, this implies that the root of the fault is in the first section 1 **303a.**

If the measured voltage from Node 2 compared to the reference voltage is not at an expected value while the voltages from Node 1 compared to the reference voltage is at an expected value. This implies that the first section 1 **303a** is functioning properly while there is a fault in the second section 2 **303b.**

The second MCU 2 **102b** may act as a control unit for the fault detector **301**, for example for data collection and data storage.

To identify the type of the fault, the fault detector **301** may sample and store the measured voltage values. The type of fault may be for example an open cable, a loose contact, a component failure etc. When or if a fault has been identified, information indicating the fault may be stored. This may be done in for example one of the following examples:

### Example 1:

Design the fault detector **301** into an external diagnostic tool that may be used in the workshop. The fault detector **301** may be manually connected to the HVIL loop and a computer. The fault detector **301** may have a compatible user interface and may be controlled manually by the user. An example fault diagnosis process of example 1 may be:
**a)** Connect the fault detector **301** to the HVIL loop, i.e. the serially connected components **105**, and to a personal computer.
**b)** Activate the HVIL loop of components **105**, e.g. sending a current signal through the HVIL loop and supply the serially connected components **105** with current.
**c)** Activate the fault detector **301** through a user interface on the personal computer, i.e. which nodes to measure/amount of measurement points.
**d)** The fault detector **301** may start measuring voltage and sampling.
**e)** The measured voltage values may be stored and plotted in a time-series plot.
**f)** The measured voltage values may be examined to identify the type and the root of the fault. A result of the examination may be stored, for example information indicating the type and root of the fault may be stored.

### Example 2:

The fault detector **301** may be a standalone component that is compatible with the CAN network and ready to be implemented into the vehicle **100.** The functions of the fault detector **301** may be automated, and it may be a standalone component connected to the HVIL loop, i.e. connected to the components **105.** An example fault diagnosis process of example 2 may be:
**a)** The fault detector **301** may continuously monitor and compare the voltage behaviours in the different sections **303** of the loop.
**b)** Whenever a user set voltage threshold value has been reached, the fault detector **301** may activate and start sampling for a specified time in the section **303** where the voltage threshold value was reached.
**c)** The measured voltage values may be stored for further usage.
**d)** The measured voltage values may be examined to identify the type and the root of the fault. A result of the examination may be stored, for example information indicating the type and root of the fault may be stored.

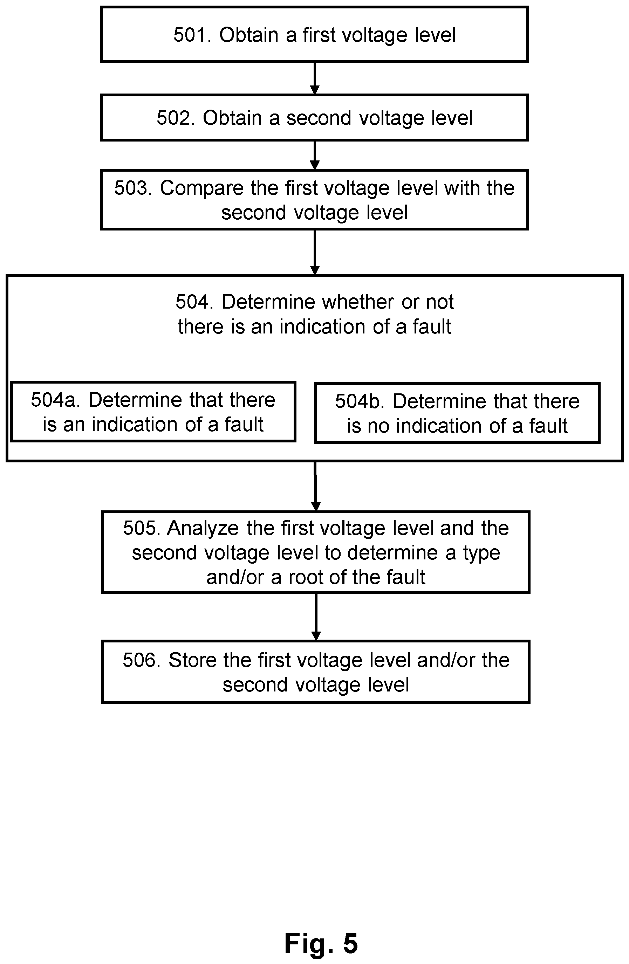

**FIG. 5** is a flow chart of a method for detecting faults in components **105** according to an example. The components **105** may be for example a traction battery, a DC/DC converter, an air compressor or any other suitable component comprised in the vehicle **100.** The method is performed by the fault detector **301.** The fault detector **301** may be a processing circuity, or it may comprise a processing circuit. The method may be performed by a processing circuitry of a computer system. The fault detector **301** may be arranged to detect a fault such as an open cable, a loose contact, a component failure etc. The method may be a computer-implemented method. The method comprises at least one of the following steps, which steps may be performed in any suitable order than described below:

Step **501:** The fault detector **301** obtains a first voltage level at an input point into each section 303. The first voltage level may be obtained continuously. The first voltage level may be obtained at a sampling rate below 10 milliseconds. The faster the sampling rate, the better. A faster sampling rate may provide more accuracy in determining the type/root of the fault. 10 milliseconds may be a minimum in order to be able to capture the voltage spikes. Consequently, the fault detector **301** comprises a voltage level measuring unit arranged to measure and obtain the voltage level at the input point and the output point. The first voltage level may be obtained at one time instance or during a time period. The time period may be for example from 200 ms to 10000 ms, i.e. from 0.2 s till 10 s.

Step **502:** The fault detector **301** obtains a second voltage level at an output point from each section 303. The second voltage level may be obtained continuously. The second voltage level may be obtained at a sampling rate below 10 milliseconds. A faster sampling rate may provide more accuracy in determining the type/root of the fault. 10 milliseconds may be a minimum in order to be able to capture the voltage spikes. The output point may be referred to as a reference point. The second voltage level may be obtained at one time instance or during a time period. The time period may be for example from 200 ms to 10000 ms, i.e. from 0.2 s till 10 s.

Step **503:** The fault detector **301** compares the first voltage level with the second voltage level for each section and such that the voltage level over each section **303** is determined. The voltage level over each section **303** is determined based on a comparison of the first voltage level and the second voltage level that are obtained from and/or measured at the input point and the output point, respectively. The voltage level over each section may be determined for one time instance or for a time period. The time period may be for example from 200 ms to 10000 ms, i.e. from 0.2 s till 10 s.

Determining the voltage level over each section **303** mya be referred to as estimating the voltage level. By comparing the voltage values, it may be possible to narrow down the root of the faulty behaviour to a section such that it may be determined that the faulty behaviour originates from a particular section **303.** Step **504:** Based on a result of the comparison, the fault detector **301** determines whether or not there is an indication of a fault in each section 303. The fault may be for example an open cable, a loose contact, a component failure etc.

Step **504a:** This may be a substep of step **504.** The fault detector **301** may determine that there is an indication of a fault in the section **303** when the result of the comparing indicates a difference between the first voltage level and the second voltage level and/or indicates that the difference has reached or exceeded a voltage threshold.

Step **504b:** This may be a substep of step **504.** The fault detector **301** may determine that there is no indication of fault in the section 303 when the result of the comparing does not indicate a difference between the first voltage level and the second voltage level and/or that the difference has not reached or exceeded a voltage threshold. Information indicating that there is no fault may be provided to a display unit arranged to display the information visible to an operator.

Step **505:** When there is an indication of the fault, the fault detector **301** may analyze or trigger an analysis of the first voltage level and the second voltage level to determine a type and/or a root of the fault. An indication of the fault may be that there is a difference between the first voltage level and the second voltage level, or that this difference has reached or exceeded a voltage threshold. The indication may be for a specific time instance or for a time period. The time period may be for example from 200ms to 10000ms, i.e. from 0.2s to 10s. The indication of the fault may be referred to as a fault signal or a faulty signal. By analyzing the length and the behaviour of the indication of the fault, the type of the fault may be determined, if it is a loose contact or a fully open circuit fault. For example if the voltage spike is only 1ms long then it is most likely a loose contact fault, if the spike is more than 10ms long then it is most likely an open circuit fault.

Information indicating the fault may be provided to a display unit arranged to display the information indicating the fault so that an operator may take a decision on how to handle the fault. Thus, early warning information may be provided to the display unit, so that the operator can quickly repair the fault and reduce the repair time.

Step **506:** The fault detector **301** may store the first voltage level and/or the second voltage level. The fault detector **301** may store information indicating the result of the comparison, e.g. information indicating the voltage level over each section **303**, the fault, the root of the fault, the type of the fault etc. The storing of the first voltage level and/or second voltage level and/or information indicating the result of the comparison may be triggered by the difference between the first voltage level and the second voltage level has reached or exceeded the voltage threshold. The first voltage level and/or the second voltage level and/or information indicating the result of the comparison may be stored in a memory, and the memory may be located onboard and/or offboard the vehicle **100.** The memory may be comprised in the fault detector **301.** The fault detector **301** may be arranged to store the first voltage level and/or the second voltage level and/or information indicating the result of the comparison only when there is an indication of a fault, or it may store it both when there is an indication of a fault and also when there is no indication of a fault.

The fault detector **301** for detecting faults in components **105** in a vehicle 100 is arranged to be connected in parallel to at least one component 105a of at least two serially connected components **105.** The HVIL **101** is arranged to be connected to a first component **105a** amongst the at least two serially connected components **105.** The at least two serially connected components **105** are divided into at least two sections **303.** Each section **303** comprises at least one component **105.** The fault detector **301** is arranged to obtain a first voltage level at an input point into each section **303** and to obtain a second voltage level at an output point from each section **303.** The first voltage level and the second voltage level may be obtained continuously. The first voltage level may be obtained at one time instance or during a time period. The time period may be for example from 200 ms to 10000 ms, i.e. from 0.2 s till 10 s.

The second voltage level may be obtained at one time instance or during a time period. The time period may be for example from 200 ms to 10000 ms, i.e. from 0.2 s till 10 s.

The fault detector **301**, is arranged to compare the first voltage level with the second voltage level for each section and such that the voltage level over each section **303** is determined. The voltage level over each section **303** may be determined at one time instance or during a time period. The time period may be for example from 200 ms to 10000 ms, i.e. from 0.2 s till 10 s.

The fault detector **301** is arranged to, based on a result of the comparison, determine whether or not there is an indication of a fault in each section **303.**

The fault detector **301** may be arranged to determine that there is an indication of a fault in the section **303** when the result of the comparing indicates a difference between the first voltage level and the second voltage level and/or indicates that the difference has reached or exceeded a voltage threshold. An indication of the fault may be that there is a difference between the first voltage level and the second voltage level, or that this difference has reached or exceeded a voltage threshold. The indication may be for a specific time instance or for a time period. The time period may be for example from 200ms to 10000ms, i.e. from 0.2s to 10s.

The fault detector **301** may be arranged to determine that there is no indication of fault in the section **303** when the result of the comparing does not indicate a difference between the first voltage level and the second voltage level and/or that the difference has not reached or exceeded a voltage threshold.

The fault detector **301** may be arranged to, when there is an indication of the fault, analyze the first voltage level and the second voltage level to determine a type and/or a root of the fault.

The fault detector **301** may be arranged to store the first voltage level and/or the second voltage level. The fault detector **301** may be arranged to store information indicating the result of the comparison, e.g. information indicating the voltage level over each section **303,** the fault, the root of the fault, the type of the fault etc. The storing of the first voltage level and/or second voltage level and/or information indicating the result of the comparison may be triggered by the difference between the first voltage level and the second voltage level has reached or exceeded the voltage threshold. The first voltage level and/or the second voltage level and/or information indicating the result of the comparison may be stored in a memory, and the memory may be located onboard and/or offboard the vehicle **100.** The memory may be comprised in the fault detector **301.** The fault detector **301** may be arranged to store the first voltage level and/or the second voltage level and/or information indicating the result of the comparison only when there is an indication of a fault, or it may store it both when there is an indication of a fault and also when there is no indication of a fault.

A fault detection system **300** for detecting faults in components **105** in a vehicle 100. The fault detection system **300** comprises a fault detector **301** described herein and at least two serially connected components **105.**

The vehicle **100** comprises the fault detection system **300** described herein.

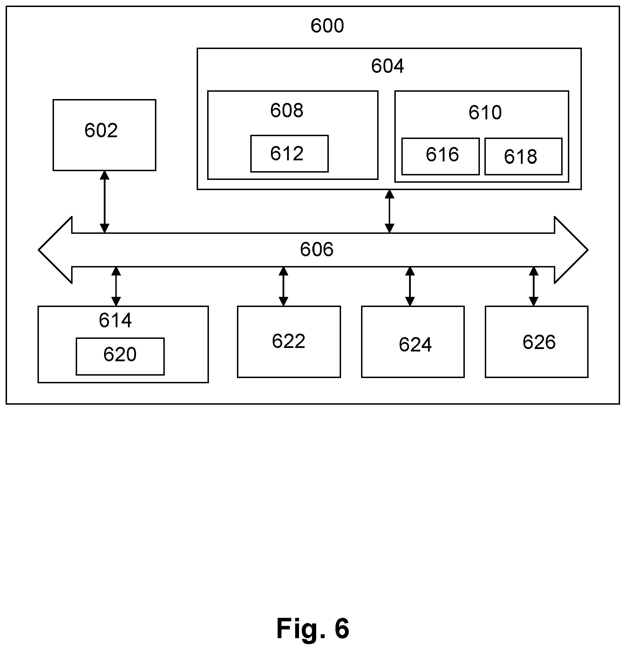

**FIG. 6** is a schematic diagram of a computer system **600** for implementing examples disclosed herein. The computer system **600** is adapted to execute instructions from a computer-readable medium to perform these and/or any of the functions or processing described herein. The computer system **600** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **600** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **600** may comprise at least one computing device or electronic device capable of including firmware, hardware, and/or executing software instructions to implement the functionality described herein. The computer system **600** may include processing circuitry **602** (e.g., processing circuitry including one or more processor devices or control units), a memory **604**, and a system bus **606.** The computer system **600** may include at least one computing device having the processing circuitry **602.** The system bus **606** provides an interface for system components including, but not limited to, the memory **604** and the processing circuitry **602.** The processing circuitry **602** may include any number of hardware components for conducting data or signal processing or for executing computer code stored in memory **604.** The processing circuitry **602** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **602** may further include computer executable code that controls operation of the programmable device.

The system bus **606** may be any of several types of bus structures that may further interconnect to a memory bus (with or without a memory controller), a peripheral bus, and/or a local bus using any of a variety of bus architectures. The memory **604** may be one or more devices for storing data and/or computer code for completing or facilitating methods described herein. The memory **604** may include database components, object code components, script components, or other types of information structure for supporting the various activities herein. Any distributed or local memory device may be utilized with the systems and methods of this description. The memory **604** may be communicably connected to the processing circuitry **602** (e.g., via a circuit or any other wired, wireless, or network connection) and may include computer code for executing one or more processes described herein. The memory **604** may include non-volatile memory **608** (e.g., read-only memory (ROM), erasable programmable read-only memory (EPROM), electrically erasable programmable read-only memory (EEPROM), etc.), and volatile memory **610** (e.g., random-access memory (RAM)), or any other medium which can be used to carry or store desired program code in the form of machine-executable instructions or data structures and which can be accessed by a computer or other machine with processing circuitry **602.** A basic input/output system (BIOS) **612** may be stored in the non-volatile memory **608** and can include the basic routines that help to transfer information between elements within the computer system **600.**

The computer system **600** may further include or be coupled to a non-transitory computer-readable storage medium such as the storage device **614**, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **614** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **614** and/or in the volatile memory **610**, which may include an operating system **616** and/or one or more program modules **618.** All or a portion of the examples disclosed herein may be implemented as a computer program **620** stored on a transitory or non-transitory computer-usable or computer-readable storage medium (e.g., single medium or multiple media), such as the storage device **614**, which includes complex programming instructions (e.g., complex computer-readable program code) to cause the processing circuitry **602** to carry out actions described herein. Thus, the computer-readable program code of the computer program **620** can comprise software instructions for implementing the functionality of the examples described herein when executed by the processing circuitry **602.** In some examples, the storage device **614** may be a computer program product (e.g., readable storage medium) storing the computer program **620** thereon, where at least a portion of a computer program **620** may be loadable (e.g., into a processor) for implementing the functionality of the examples described herein when executed by the processing circuitry **602.** The processing circuitry **602** may serve as a controller or control system for the computer system **600** that is to implement the functionality described herein.

The computer system **600** may include an input device interface **622** configured to receive input and selections to be communicated to the computer system **600** when executing instructions, such as from a keyboard, mouse, touch-sensitive surface, etc. Such input devices may be connected to the processing circuitry **602** through the input device
interface **622** coupled to the system bus **606** but can be connected through other interfaces, such as a parallel port, an Institute of Electrical and Electronic Engineers (IEEE) 1394 serial port, a Universal Serial Bus (USB) port, an IR interface, and the like. The computer system **600** may include an output device interface **624** configured to forward output, such as to a display, a video display unit (e.g., a liquid crystal display (LCD) or a cathode ray tube (CRT)). The computer system **600** may include a communications interface **626** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

**Example 1:** A method performed by a fault detector **301** for detecting faults in components **105** in a vehicle **100**, wherein the fault detector **301** is connected in parallel to at least one component **105** of at least two serially connected components **202**, wherein the HVIL **101** is connected to a first component **105a** amongst the at least two serially connected components **105**, wherein the at least two serially connected components **105** are divided into at least two sections **303**, wherein each section **303** comprises at least one component **105**, the method comprising:
- obtaining **501** a first voltage level at an input point into each section **303**;
- obtaining **502** a second voltage level at an output point from each section **303**;
- comparing **503** the first voltage level with the second voltage level for each section and such that the voltage level over each section **303** is determined; and
- based on a result of the comparison, determining **504** whether or not there is an indication of a fault in each section **303.**

**Example 2**: The method of example 1, comprising:
- determining **504a** that there is an indication of a fault in the section **303** when the result of the comparing indicates a difference between the first voltage level and the second voltage level and/or indicates that the difference has reached or exceeded a voltage threshold.

**Example 3**: The method of example 1, comprising:
- determining **504b** that there is no indication of fault in the section **303** when the result of the comparing does not indicate a difference between the first voltage level and the second voltage level and/or that the difference has not reached or exceeded a voltage threshold.

**Example 4**: The method of any of examples 1-3, comprising:
- when there is an indication of the fault, analyzing **505** the first voltage level and the second voltage level to determine a type and/or a root of the fault.

**Example 5**: The method of any of examples 1-4, wherein the first voltage level and the second voltage level are obtained continuously.

**Example 6**: The method of any of examples 1-5 comprising:
- storing **506** the first voltage level and/or the second voltage level and/or information indicating the result of the comparison.

**Example 7**: The method of example 6, wherein the storing of the first voltage level and/or second voltage level and/or information indicating the result of the comparison is triggered by that the difference between the first voltage level and the second voltage level has reached or exceeded the voltage threshold.

**Example 8**: The method of any of examples 1-7, wherein the first voltage level and the second voltage level are obtained at a sampling rate below 10 milliseconds.

**Example 9**: A fault detector **301** for detecting faults in components **105** in a vehicle **100**, wherein the fault detector **301** is arranged to be connected in parallel to at least one component **105a** of at least two serially connected components **105**, wherein the HVIL **101** is arranged to be connected to a first component **105a** amongst the at least two serially connected components **105**, wherein the at least two serially connected components **105** are divided into at least two sections **303**, wherein each section **303** comprises at least one component **105**, the fault detector **301** being arranged to:
- obtain a first voltage level at an input point into each section **303**;
- obtain a second voltage level at an output point from each section **303**;
- compare the first voltage level with the second voltage level for each section and such that the voltage level over each section **303** is determined; and to
- based on a result of the comparison, determine whether or not there is an indication of a fault in each section **303.**

**Example 10**: The fault detector **301** of example 9, arranged to:
- determine that there is an indication of a fault in the section **303** when the result of the comparing indicates a difference between the first voltage level and the second voltage level and/or indicates that the difference has reached or exceeded a voltage threshold.

**Example 11**: The fault detector **301** of any of examples 9-10, arranged to:
- determine that there is no indication of fault in the section **303** when the result of the comparing does not indicate a difference between the first voltage level and the second voltage level and/or that the difference has not reached or exceeded a voltage threshold.

**Example 12**: The fault detector **301** of any of examples 9-11, arranged to:
- when there is an indication of the fault, analyze the first voltage level and the second voltage level to determine a type and/or a root of the fault.

**Example 13**: The fault detector **301** of any of examples 9-12, wherein the first voltage level and the second voltage level are obtained continuously.

**Example 14**: The fault detector **301** of any of examples 9-13, arranged to:
- store the first voltage level and/or the second voltage level and/or information indicating the result of the comparison.

**Example 15**: The fault detector **301** of example 14, wherein the storing of the first voltage level and/or second voltage level and/or information indicating the result of the comparison is triggered by that the difference between the first voltage level and the second voltage level has reached or exceeded the voltage threshold.

**Example 16**: The fault detector **301** of any of examples 9-15, wherein the first voltage level and the second voltage level are obtained at a sampling rate below 10 milliseconds.

**Example 17**: A fault detection system **300** for detecting faults in components **105** in a vehicle **100**, the fault detection system **300** comprises a fault detector **301** according to any of examples 9-16 and at least two serially connected components **105.**

**Example 18**: A vehicle **100** comprising the fault detection system **300** according to example 17.

**Example 19**: A computer program product comprising program code for performing, when executed by the processing circuitry, the method of any of examples 1-8.

**Example 20**: A non-transitory computer-readable storage medium comprising instructions, which when executed by the processing circuitry, cause the processing circuitry to perform the method of any of examples 1-8.

**Example 21:** A computer system comprising processing circuitry configured to perform the method of any of examples 1-8.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A method performed by a fault detector (301) for detecting faults in components (105) in a vehicle (100), wherein the fault detector (301) is connected in parallel to at least one component (105) of at least two serially connected components (202),
wherein the HVIL (101) is connected to a first component (105a) amongst the at least two serially connected components (105), wherein the at least two serially connected components (105) are divided into at least two sections (303), wherein each section (303) comprises at least one component (105), the method comprising:
*obtaining* (501) a first voltage level at an input point into each section (303);
*obtaining* (502) a second voltage level at an output point from each section (303);
*comparing* (503) the first voltage level with the second voltage level for each section and such that the voltage level over each section (303) is determined; and
based on a result of the comparison, *determining* (504) whether or not there is an indication of a fault in each section (303).

2. The method of claim 1, comprising:
*determining* (504a) that there is an indication of a fault in the section (303) when the result of the comparing indicates a difference between the first voltage level and the second voltage level and/or indicates that the difference has reached or exceeded a voltage threshold.

3. The method of claim 1, comprising:
*determining* (504b) that there is no indication of fault in the section (303) when the result of the comparing does not indicate a difference between the first voltage level and the second voltage level and/or that the difference has not reached or exceeded a voltage threshold.

4. The method of any of claims 1-3, comprising:
when there is an indication of the fault, *analyzing* (505) the first voltage level and the second voltage level to determine a type and/or a root of the fault.

5. The method of any of claims 1-4, wherein the first voltage level and the second voltage level are obtained continuously.

6. The method of any of claims 1-5 comprising:
*storing* (506) the first voltage level and/or the second voltage level and/or information indicating the result of the comparison.

7. The method of claim 6, wherein the storing of the first voltage level and/or second voltage level and/or information indicating the result of the comparison is triggered by that the difference between the first voltage level and the second voltage level has reached or exceeded the voltage threshold.

8. The method of any of claims 1-7, wherein the first voltage level and the second voltage level are obtained at a sampling rate below 10 milliseconds.

9. A fault detector (301) for detecting faults in components (105) in a vehicle (100), wherein the fault detector (301) is arranged to be connected in parallel to at least one component (105a) of at least two serially connected components (105), wherein the HVIL (101) is arranged to be connected to a first component (105a) amongst the at least two serially connected components (105), wherein the at least two serially connected components (105) are divided into at least two sections (303), wherein each section (303) comprises at least one component (105), the fault detector (301) being arranged to:
obtain a first voltage level at an input point into each section (303);
obtain a second voltage level at an output point from each section (303);
compare the first voltage level with the second voltage level for each section and such that the voltage level over each section (303) is determined; and to
based on a result of the comparison, determine whether or not there is an indication of a fault in each section (303).

10. The fault detector (301) of claim 9, arranged to:
*determine* that there is an indication of a fault in the section (303) when the result of the comparing indicates a difference between the first voltage level and the second voltage level and/or indicates that the difference has reached or exceeded a voltage threshold.

11. The fault detector (301) of any of claims 9-10, arranged to:
*determine* that there is no indication of fault in the section (303) when the result of the comparing does not indicate a difference between the first voltage level and the second voltage level and/or that the difference has not reached or exceeded a voltage threshold.

12. The fault detector (301) of any of claims 9-11, arranged to:
when there is an indication of the fault, analyze the first voltage level and the second voltage level to determine a type and/or a root of the fault.

13. The fault detector (301) of any of claims 9-12, wherein the first voltage level and the second voltage level are obtained continuously.

14. A fault detection system (300) for detecting faults in components (105) in a vehicle (100), the fault detection system (300) comprises a fault detector (301) according to any of claims 9-13 and at least two serially connected components (105).

15. A vehicle (100) comprising the fault detection system (300) according to claim 14.
